# EUROPEAN PATENT APPLICATION

(11) **EP 4 711 089 A1**
(43) Date of publication of application: **18.03.2026**
(21) Application number: 25194663.8
(22) Date of filing: 07.08.2025
(51) Int. Cl.: B25C 1/06, B25F 5/00

(54) **POWERED FASTENER DRIVER WITH MULTIPLE COOLING AIRFLOW PATHS**

(30) Priority: 07.08.2024 US 202463680454 P
(71) Applicant: Techtronic Cordless GP, Anderson, SC 29621 (US)
(72) Inventor: Caso, III, Michael J., Anderson, 29621 (US); Hoeler, Ryan J., Anderson, 29621 (US); Gambhir, Venkat Praveen, Anderson, 29621 (US)
(74) Representative: Meissner Bolte Partnerschaft mbB

(57) **Abstract**

A power tool with a housing, a motor, and a printed circuit board. The housing includes a motor housing portion and a battery receptacle portion separate from the motor housing portion. The motor is coupled to and configured to drive a working element and at least one impeller, the motor positioned at least partially within the motor housing portion, the battery receptacle portion including a receptacle configured to receive a battery pack to provide electrical current to the motor. The printed circuit board includes a heat-generating electrical component, the printed circuit board positioned within the battery receptacle portion. The at least one impeller is configured to generate airflow in a first airflow path within the motor housing portion and airflow in a second airflow path within the battery receptacle portion, the first airflow path and second airflow path being separate from one another.

## Description

### CROSS-REFERENCE TO RELATED APPLICATIONS

This application claims priority to U.S. Provisional Patent Application No. 63/680,454 filed on August 7, 2024, the entire content of which is incorporated herein by reference.

### FIELD OF THE INVENTION

The present invention relates to powered fastener drivers, and more specifically to cooling arrangements for powered fastener drivers.

### BACKGROUND OF THE INVENTION

Various fastener drivers are known in the art for driving fasteners (e.g., nails, tacks, staples, etc.) into a workpiece. Powered fastener drivers include motors which utilize electrical power to provide mechanical force to drive or load a mechanism to drive the fastener. Motors generate heat upon activation. Some power tools include heat generating electrical components that control power supply to motors.

### SUMMARY OF THE INVENTION

The present invention provides, in one aspect, a power tool comprising a housing, a motor, and a printed circuit board including a heat-generating electrical component. The housing includes a motor housing portion and a battery receptacle portion separate from the motor housing portion. The motor is coupled to and configured to drive a working element and at least one impeller. The motor is positioned at least partially within the motor housing portion, the battery receptacle portion including a receptacle configured to receive a battery pack to provide electrical current to the motor. The printed circuit board includes a heat-generating electrical component and is positioned within the battery receptacle portion. The impeller is configured to generate airflow in a first airflow path within the motor housing portion and airflow in a second airflow path within the battery receptacle portion. The first airflow path and second airflow path are separate from one another.

The present invention provides, in another independent aspect, a power tool comprising a housing, a motor, a wall within the housing, and a printed circuit board including a heat-generating electrical component. The housing includes a motor housing portion and a battery receptacle portion. The motor is coupled to and configured to drive a working element and at least one impeller. The motor is positioned at least partially within the motor housing portion, and the battery receptacle potion includes a receptacle configured to receive a battery pack to provide electrical current to the motor. The printed circuit board is positioned within the battery receptacle portion. The wall separates the motor housing portion and the battery receptacle portion. The impeller is configured to generate airflow in a first airflow path within the motor housing portion and in a second airflow path within the battery receptacle portion. The first airflow path and the second airflow path are separated from one another by the wall.

The present invention provides, in another independent aspect, a powered fastener driver comprising a housing, a wall, a cylinder, a piston, a driver blade, a motor, a printed circuit board, a first impeller, and a second impeller. The housing includes a motor housing portion and a battery receptacle portion. The wall is within the housing and separates the motor housing portion and the battery receptacle portion. The cylinder is disposed within the housing. The piston is positioned and movable within the cylinder along a drive axis between a working end and a distal end opposite the working end. The driver blade is attached to and movable with the piston. The motor is to drive movement of the piston. The motor is positioned within the motor housing portion. The motor includes a rotor shaft. The battery receptacle portion includes a receptacle configured to receive a battery pack to provide electrical current to the motor. The printed circuit board includes a heat-generating electrical component and is positioned in the battery receptacle portion. The first impeller is coupled to the rotor shaft within the motor housing portion and is configured to generate airflow in a first airflow path within the motor housing portion. The second impeller is coupled to the rotor shaft within the battery receptacle portion and is configured to generate airflow in a second airflow path within the battery receptacle portion.

Other features and aspects of the invention will become apparent by consideration of the following detailed description and accompanying drawings.

### BRIEF DESCRIPTION OF THE DRAWINGS

FIG. 1 is a perspective view of a gas spring-powered fastener driver.
FIG. 2 is another perspective view of the gas spring-powered fastener driver of FIG. 1.
FIG. 3 is another perspective view of the gas spring-powered fastener driver of FIG. 1.
FIG. 4 is a cross-sectional view of the gas spring-powered fastener driver of FIG. 1 taken along section line 4-4 in FIG. 1.
FIG. 5 is an enlarged cross-sectional view of the gas spring-powered fastener driver of FIG. 1 taken along section line 4-4 in FIG. 1.
FIG. 6 is a cross-sectional view of the gas spring-powered fastener driver of FIG. 1 taken along section line 6-6 in FIG. 1.
FIG. 7 is cross-sectional view of the gas spring-powered fastener driver of FIG. 1 taken along section line 7-7 in FIG. 1.
FIG. 8 is a perspective view of a gas spring powered fastener driver.
FIG. 9 is another perspective view of the gas spring powered fastener driver of FIG. 8.
FIG. 10 is another perspective view of the gas spring powered fastener driver of FIG. 8.

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting.

### DETAILED DESCRIPTION

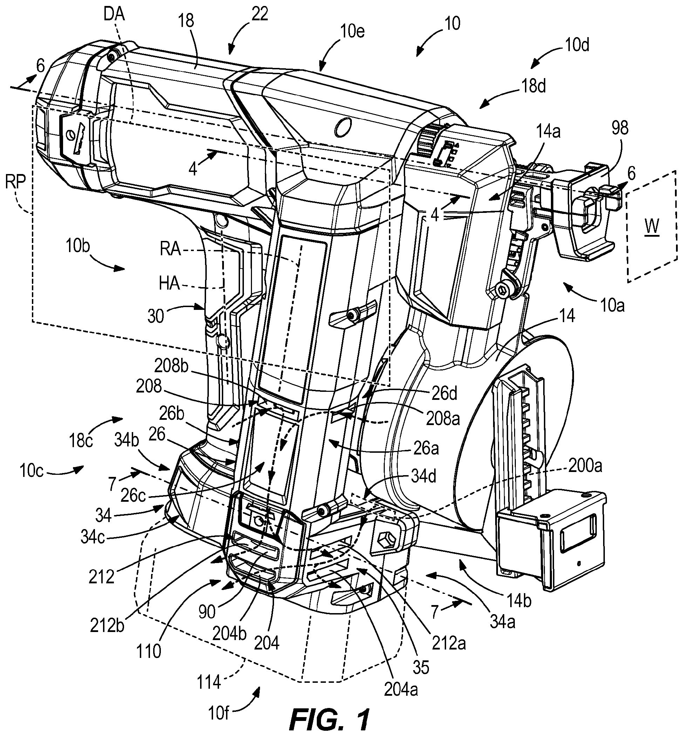

With reference to FIGS. 1-7, a power tool such as gas spring-powered fastener driver 10 (i.e., the driver 10) is operable to drive fasteners (e.g., nails, tacks, staples, etc.) held within a magazine 14 into a workpiece W. As illustrated in FIG. 1, the driver 10 has working end 10a (i.e., forward longitudinal side) from which fasteners are ejected and an opposite distal end 10b (i.e., rearward longitudinal side); first and second lateral sides 10c, 10d; and first and second vertical sides 10e, 10f.

In the illustrated embodiment, the above-described first lateral side 10c is a right (i.e., starboard) side of the fastener driver 10, and the above-described second lateral side 10d is a left (i.e., port) side of the fastener driver 10. In the illustrated embodiment, the above described first vertical side 10e may be described as a top side of the fastener driver 10, and the second vertical side 10f may be described as a bottom side of the fastener driver 10. The working end 10a faces in a forward direction. The distal end 10b faces a rearward direction. The first and second lateral sides 10c, 10d, face right and left directions, respectively. The first and second vertical sides 10e, 10f face upward and downward directions. The terminology describing the sides of the driver 10 may be altered depending on orientation of the driver 10 as a whole. The illustrated driver 10 is described with regard to a workpiece W that is forward of the working end 10a. However, the driver 10 can be maneuvered by a user to other orientations. For example, the driver 10 may be oriented with the working end 10a facing vertically downward with respect to the ground to drive a fastener into a workpiece W that faces vertically upward from the ground. Other orientations are possible. For consistency, the application will refer to the working end 10a as the same side of the driver 10 independent of the orientation of the driver 10 as a whole.

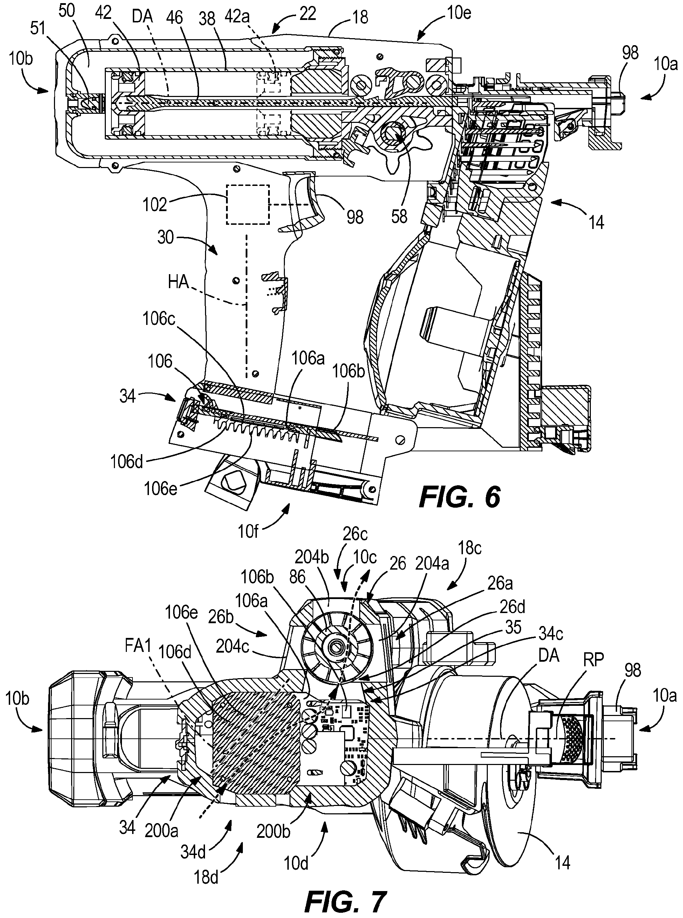

With reference to FIGS. 1, 6, and 7, the driver 10 includes a housing 18 with a cylinder housing portion 22, a motor housing portion 26, a handle housing portion 30, and a battery receptacle portion 34. The motor housing portion 26 and battery receptacle portion 34 are fluidly connected to one another by a passageway 35. As shown in FIG. 7, the passageway 35 may interconnect the motor housing portion 26 and the battery receptacle portion 34 with the passageway 35 extending in a lateral direction between a right lateral side 34c of the battery receptacle portion 34 and a left lateral side 26d of the motor housing portion 26. The illustrated passageway 35 is located entirely on the first lateral side 10c of the reference plane RP. As illustrated in FIGS. 1 and 6, the cylinder housing portion 22 extends along a drive axis DA. The drive axis DA extends between the working end 10a of the driver 10 (which generally corresponds with a working end/bottom dead center (BDC) position of piston 42) and a distal end 10b of the driver 10 (which generally corresponds with a distal end/top dead center (TDC) position of piston 42, as described in detail below). Adjacent the distal end 10b, the handle housing portion 30 extends generally perpendicularly from the drive axis DA between the first vertical side 10e and the second vertical side 10f and along a handle axis HA. The first lateral side 10c and second lateral side 10d are bisected by a reference plane RP (FIG. 1) that intersects the drive axis DA and the handle axis HA. The housing 18 may be a multi-piece clamshell type housing split along the reference plane RP. The reference plane RP generally splits the housing 18 (e.g., both the handle housing portion 30 and the cylinder housing portion 22) into a left lateral side 18c and a right lateral side 18d. In some embodiments, the housing 18 may physically be made of separated clamshell halves which are separated at the reference plane RP. However, the housing 18 need not be made of clamshell construction, or may be bisected by a reference plane RP not intersecting the drive axis DA. The battery receptacle portion 34 is coupled to a distal end of the handle housing portion 30 spaced from the cylinder housing portion 22. The battery receptacle portion 34 is also coupled to the motor housing portion 26 at a distal end of the motor housing portion 26 spaced from the cylinder housing portion 22.

With reference to FIG. 1, the motor housing portion 26 includes a left lateral side 26d closest to the first side 18d of the housing 18, and an opposite a right lateral side 26c on the second side 18c of the housing 18, a forward longitudinal side 26a facing the working end 10a (e.g., of the driver 10 as a whole, or as described in relation to the drive axis DA), and a rearward longitudinal side 26b facing the distal end 10b.

With continued reference to FIG. 1, the battery receptacle portion 34 includes a left lateral side 34d on the first side 18d of the housing 18, a right lateral side 34c on the second side 18c of the housing 18, a forward longitudinal side 34a facing the working end 10a (e.g., of the driver 10 as a whole, or as described in relation to the drive axis DA), and a rearward longitudinal side 34b facing the distal end 10b.

The motor housing portion 26 extends generally perpendicularly from the drive axis DA between the first vertical side 10e and the second vertical side 10f and along a rotary axis RA. The motor housing portion 26 may be laterally offset from the drive axis DA. In the illustrated embodiment, the motor housing portion 26 is laterally offset from the drive axis DA on the first (right) lateral side 10c of the driver 10. In other embodiments, the motor housing portion 26 may be positioned on the second (left) lateral side 10d of the driver 10. Alternatively, in other embodiments the motor housing portion 26 may be laterally aligned with the drive axis DA.

Each portion of the housing 18 may house different components of the driver 10. Generally, the cylinder housing portion 22 houses components related to driving fasteners from the magazine 14 into the workpiece W. The driver 10 may include a piston cylinder 38 disposed within the cylinder housing portion 22 and a moveable piston 42 (i.e., a drive piston 42) positioned within the piston cylinder 38. The cylinder housing portion 22 is arranged as at least partially enclosing the piston cylinder 38. The piston 42 is movable (e.g., translatable in a reciprocating manner in either direction) along the drive axis DA. The driver 10 may further include a driver blade 46 that is attached to the piston 42 and moveable therewith. The driver blade 46 may be described as a working element of the driver 10. Other power tools may have different working elements. The driver 10 may include an outer storage chamber cylinder 50 that defines a storage chamber 54 in which compressed gas is stored. The storage chamber 54 is in fluid communication with the piston cylinder 38. In the illustrated embodiment, the storage chamber cylinder 50 is coaxial with the piston cylinder 38, the drive piston 42, and the driver blade 46 along the drive axis DA. The outer storage chamber cylinder 50 may be positioned within the cylinder housing portion 22 of the housing 18. The piston 42 and thus the driver blade 46 are movable along the drive axis DA between a bottom-dead-center (i.e., BDC) position (illustrated with piston 42, FIG. 6) and a top-dead-center (i.e., TDC) position (illustrated with piston 42, FIG. 6). The illustrated driver 10 may be a gas-spring powered fastener driver 10. Other similar pneumatic or otherwise powered fastener drivers 10 are possible. As illustrated in FIG. 6, the fastener driver 10 may include a fill port 51 configured to receive external gas and pass external gas into the storage chamber cylinder 50.

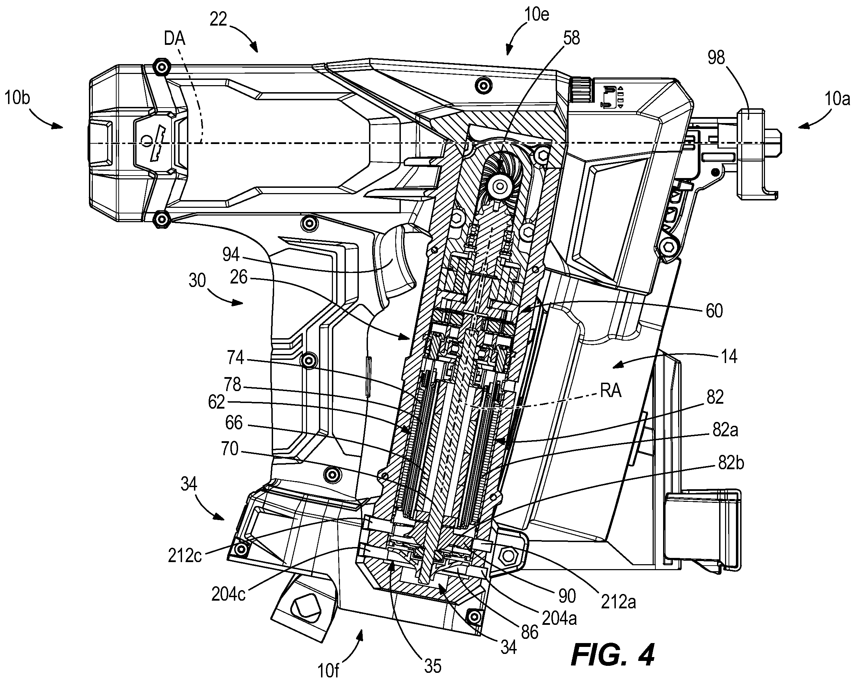

The cylinder housing portion and/or the motor housing portion 26 may generally house components related to lifting the drive piston 42. With reference to FIGS. 4 and 6, the driver 10 further includes a lifting assembly 58 positioned proximal to the working end 10a. During a driving cycle and as described in detail below, the driver blade 46 and piston 42 may be movable between the loaded or TDC position (piston 42) and a driven or BDC (piston 42a). The lifting assembly 58 may be powered by a motor 62 which is operable to move the driver blade 46 from the driven or BDC position (piston 42a) to the loaded or TDC position (piston 42). This movement (e.g., retraction) of the driver blade 46 forces the piston 42 to apply pressure to the gas in the storage chamber 54 to repressurize the gas in the storage chamber 54 for subsequent firing.

The motor 62 is positioned within the motor housing portion 26. The motor 62 includes a rotor 66 with a rotor shaft 70 and a stator 74 with stator windings 78. The stator windings 78 are selectively energized to drive the rotor 66. The motor 62 is positioned within a casing 82. The casing 82 includes an annular wall 82a that surrounds the motor 62 and is positioned within the motor housing portion 26. The casing 82 further includes an end wall 82b that separates an interior of the motor housing portion 26 from an interior of the battery receptacle portion 34. In other embodiments, the housing 18 may define one or more walls that separate the interior of the motor housing portion 26 from the interior of the battery receptacle portion 34. The illustrated motor 62 is an inner rotor motor with the rotor 66 (more specifically, the rotor shaft 70) oriented along a rotary axis RA with the stator 74 positioned radially outboard of the rotor 66 with respect to the rotary axis RA. Other embodiments may utilize outer rotor motors or other types of motors.

A gearbox 60 may be positioned in mechanical contact with and between the motor 62 and the lifting assembly 58. The gearbox 60 may be physically positioned within motor housing portion 26. In other embodiments, the gearbox 60 may be positioned in other portions of the housing 18 such as the cylinder housing portion 22. In other embodiments, the gearbox 60 can be circumvented, with the motor 62 being directly coupled to the lifting assembly 58.

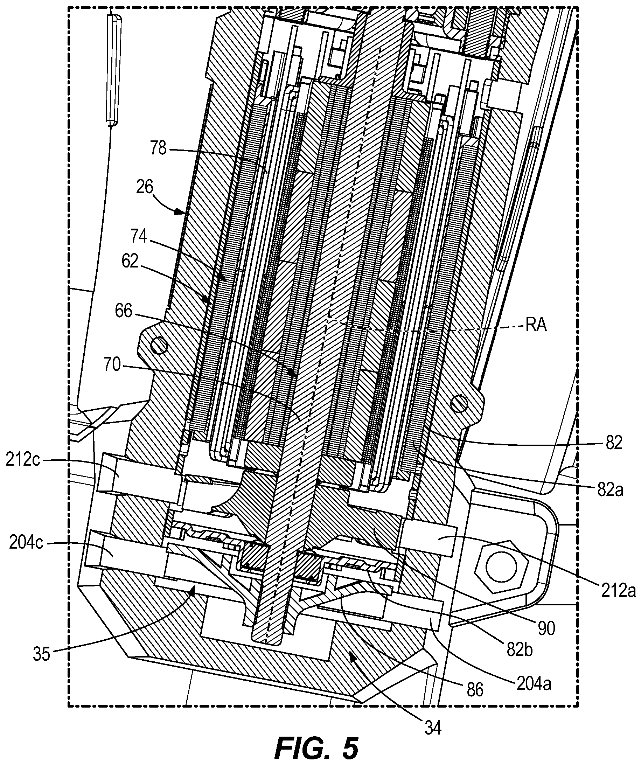

With reference to FIGS. 4 and 5, the rotor shaft 70 is coupled to a foot impeller 86 (i.e., fan) in the battery receptacle portion 34 and a motor impeller 90 (i.e., fan) in the motor housing portion 26. In the illustrated embodiment, the foot impeller 86 is coupled to the rotor shaft 70 at a distal end of the rotor shaft 70 opposite the gearbox 60. The rotor shaft 70 passes through the end wall 82b of the casing 82 with the foot impeller 86 and the motor impeller 90 on opposite sides of the end wall 82b. Upon activation of the motor, the rotor shaft 70 drives both the foot impeller 86 and the motor impeller 90. The foot impeller 86 drives foot airflow AF1 through the battery receptacle portion 34, and the motor impeller 90 drives motor airflow AF2 through the motor housing portion 26.

The foot impeller 86 and the motor impeller 90 may be designed in any manner. The illustrated foot impeller 86 and motor impeller 90 are designed as centrifugal fans capable of sucking air through the battery receptacle portion 34, and the motor housing portion 26 respectively. The foot impeller 86 is capable of sucking foot airflow AF 1 laterally through the battery receptacle portion 34 and, one generally aligned with the motor housing portion 26, upwardly along the rotary axis RA from the second (bottom) vertical side 10f toward the first (top) vertical side 10e. The motor impeller 90 is capable of sucking motor airflow AF2 generally vertically along the rotary axis RA through the motor 62 from the first (top) vertical side 10e toward the second (bottom) vertical side 10f.

The housing 18 of the driver 10 includes a plurality of inlets and outlets to facilitate ingress and egress of fluid flow into and out of the driver 10 as driven by the foot impeller 86 and the motor impeller 90.

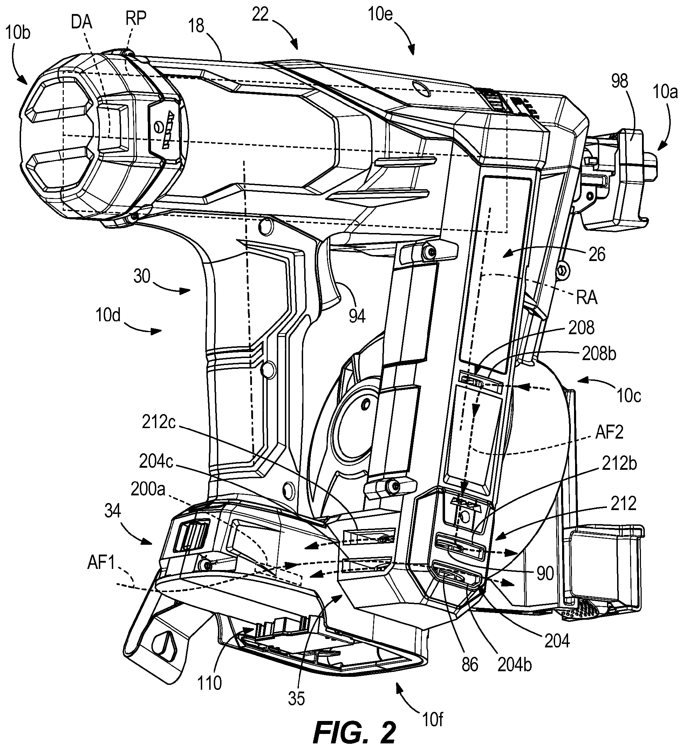

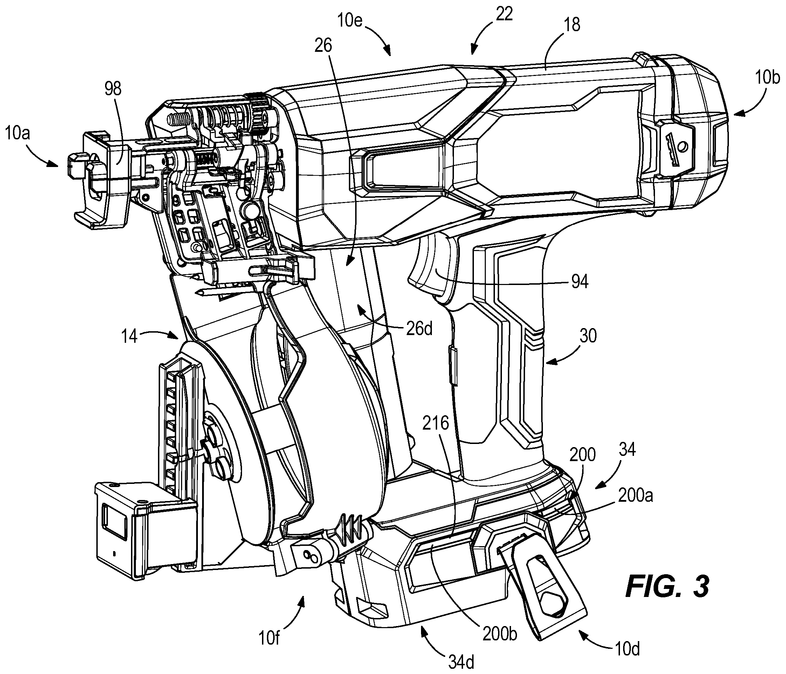

As illustrated in FIG. 3, the housing 18 includes two foot inlet openings 200a, 200b each positioned on the second lateral side 10d and in the battery receptacle portion 34. Other embodiments may include one or more than two foot inlet openings 200. As illustrated in FIGS. 1 and 2, the housing 18 includes three foot outlet openings 204. A first foot outlet opening 204a faces the working end 10a. A second foot outlet opening 204b faces the first (right) lateral side 10c. A third foot outlet opening 204c faces the distal end 10b. Other embodiments may include more or fewer foot outlet openings 204, which may direct airflow exiting the driver 10 in any desired direction. Each of the openings 200, 204 are through holes through the sidewalls of the battery receptacle portion 34 that permit fluid communication between the interior of the battery receptacle portion 34 and the surroundings (e.g., ambient air) of the driver 10. In some embodiments, one or more baffles 216 may be positioned within or adjacent to the openings 200, 204 to further direct airflow as it enters the driver 10.

As illustrated in FIGS. 1 and 2, the housing 18 includes two motor inlet openings 208. A first motor inlet opening 208a is positioned on the motor housing portion 26 adjacent the working end 10a, and a second motor inlet opening 208b is positioned on the motor housing portion 26 adjacent the first (right) lateral side 10c. Other embodiments may include one or more than two motor inlet openings 208. The housing 18 further includes three foot outlet openings 212. A first motor outlet opening 212a faces the working end 10a. A second motor outlet opening 212b faces the first (right) lateral side 10c. A third motor outlet opening 212c faces the distal end 10b. Other embodiments may include more or fewer motor outlet openings 212, which may direct airflow exiting the driver 10 in any desired direction. Each of the openings 208, 212 are through holes through the sidewalls of the motor housing portion 26 that permit fluid communication between the interior of the motor housing portion 26 and the surroundings (e.g., ambient air) of the driver 10. In some embodiments, baffles (e.g., like the baffles 216) may be positioned within or adjacent to the openings 208, 212 to further direct airflow as it exists the driver 10.

The handle housing portion 30 generally includes components for user maneuvering and firing of the driver 10. The handle housing portion 30 itself may be held and maneuvered by the user to locate the driver 10 in desired position for firing. The driver 10 is selectively fired by depressing an actuating member, such as a trigger 94 and/or a contact tip 98. The driver 10 may be capable of operating in different drive mode, such as a single sequential mode and a bump fire mode, whereby different sequential actuation of the trigger 94 and the contact tip 98 actuate an electrical switch 102 to fire the driver 10. For example, in the single sequential mode, the contact tip 98 may function as a safety and be required to be depressed, for example, by mechanical contact between the contact tip 98 and the workpiece W before a user depresses the trigger 94 to activate firing of the driver. For example, in the bump fire mode, the trigger 94 may function as a safety or be disabled, and depression of the contact tip 98 against the workpiece W may cause firing of the driver 10. The contact tip 98 is positioned adjacent the working end 10a. Fasteners ejected from the driver 10 may pass through the contact tip 98. In the illustrated embodiment, the trigger 94 protrudes from the handle housing portion 30 to permit actuation of the trigger 94 from the exterior of the housing 18, and the electrical switch 102 is positioned within the handle housing portion 30.

The battery receptacle portion 34 may generally house components for connecting the driver 10 to a power source and for controlling the motor 62. The switch 102 is electrically connected to the motor 62 via a printed circuit board assembly (PCBA) 106 that functions as an electronic control unit for controlling operation of the motor 62. In the illustrated embodiment, the PCBA 106 is at least partially positioned within the battery receptacle portion 34. The battery receptacle portion 34 includes a receptacle 110 configured to receive a battery pack 114 for coupling the battery pack 114 to the motor 62. When attached to the receptacle 110, the battery pack 114 can provide electrical current to the motor 62. In the illustrated embodiment, the receptacle 110 is positioned at a lower facing end of the of the battery receptacle portion 34 at the second (bottom) vertical side 10f. Upon engagement between the battery pack 114 and the receptacle 110, the battery pack 114 may be electrically coupled to the PCBA 106. In other embodiments, the driver 10 may be a corded power tool whereby the receptacle 110 can receive input electrical power from any other power source (e.g., AC mains power).

The PCBA 106 may include a printed circuit board (PCB) 106a, a microprocessor 106b optionally mounted on the PCB 106a, one or more heat generating electrical components 106c optionally mounted on the PCB 106a and may further include one or more circuits for controlling operation of the motor 62. The heat generating electrical components 106c may be one or more field effect transistors (FETs) 106c. The PCBA 106 may further include a heat sink 106d. The heat sink 106d may be at least partially made of a thermally conductive material (e.g., Aluminum, Copper, etc.) and may include at least one heat sink fin 106e. In the embodiment illustrated in FIG. 7, the heat sink fin(s) 106e extend and are oriented in a direction along a fin axis FA1 which is transverse to the drive axis DA (i.e., transverse to the reference plane RP). Channels may be defined between adjacent heat sink fins 106e, the channels being oriented along the fin axis FA1 in a direction extending from the foot inlet opening 200a toward the foot outlet openings 204. At least one of the channels traverses (i.e., crosses) the reference plane RP. The heat sink fins 106e and thus the channels are oriented in a direction extending laterally and forwardly from the foot inlet openings 200a (i.e., printed circuit board inlet openings) and toward the passageway 35. In the illustrated embodiment, the fin axis FA1 is angled approximately 50 degrees relative to the drive axis DA. Other orientations of the fins 106e and the fin axis FA1 are possible. With this geometry and orientation, the heat sink fins 106e may direct the foot airflow AF1 both in a forward direction from the distal end 10b toward the working end 10a and from the second (left) lateral side 10d toward the first (right lateral side 10c. In the illustrated embodiment, the heat sink 106d covers only a portion of the PCB 106a. In some embodiments, the heat sink 106d may be a potting boat heat sink whereby the PCB 106a is at least partially positioned within the heat sink 106d. In the illustrated embodiment, the heat sink 106d is positioned adjacent the PCB 106a. More specifically, the heat sink 106d is positioned adjacent to and/or in mechanical contact with one or more heat-generating electric components such as the microprocessor 106b or the FETs 106c mounted on the PCB 106a. The PCBA 106 may include a plurality (e.g., six) FETs 106c mounted on the PCB 106a, the FETs 106c being configured to control the supply of electrical current to the motor 62 from the battery pack 114. In some exemplary embodiments, the FETs 106c may be mounted to the PCB 106a in an H-bridge motor driver circuit. The PCBA 106 may be supported within the housing 18 by one or more rubber mounts between the PCBA 106 and the housing 18.

In operation, beginning with the piston 42 at the BDC position, the lifting assembly 58 may drive the piston 42 and the driver blade 46 toward the TDC position by energizing the motor 62. As the piston 42 and the driver blade 46 are driven toward the TDC position, the gas above the piston 42 and the gas within the storage chamber cylinder 50 may be compressed. Prior to reaching the TDC position, the motor 62 may be deactivated and the piston 42 and the driver blade 46 are held in a ready position, which is located between the TDC and the BDC positions, until being released by user activation of the actuation member (e.g., the trigger 94 or the contact tip 98). When released, the compressed gas above the piston 42 and within the storage chamber cylinder 50 may drive the piston 42 and the driver blade 46 to the driven position (e.g., toward BDC), thereby driving a fastener from the magazine 14 into the workpiece. The illustrated driver 10 therefore operates on a gas spring principle utilizing the lifting assembly 58 and the piston 42 to further compress the gas within the piston cylinder 38 and the storage chamber cylinder 50.

During operation of the motor 62, the FETs 106c are switched on and off in rapid succession. Rapid switching of the FETs 106c generates heat. Heat generated by the FETs 106c is transferred to the heat sink 106d via conduction and due to mechanical contact between the FETs 106c and the heat sink 106d. Optionally, the FETs 106c directly mechanically contact the heat sink 106d. Optionally, the FETs 106c indirectly mechanically contact the heat sink 106d through one or more thermally conductive pads. Material of the thermally conductive pad may differ or may be the same as the heat sink 106d and the FETs 106c. In any case, heat from the FETs 106c is transferred via conduction through the heat sink 106d to the heat sink fin(s) 106e. Operation of the motor 62 also generates heat in the motor 62, for example, by the stator windings 78 being activated, and the rotor shaft 70 being rotated.

During operation of the motor 62, the foot impeller 86 and motor impeller 90 are simultaneously driven. The foot impeller 86 generates (e.g., drives) foot airflow AF1 (e.g., suction airflow) from the foot inlet opening(s) 200 to the foot outlet opening(s) 204. The heat from the FETs 106c (or any other heat-generating electrical component such as the microprocessor 106b) may be transferred via convection from the heat sink fin(s) 106e by the foot airflow AF1, and through the foot outlet opening(s) 204 exhaust from the housing 18 to the surroundings of the driver 10. Relatively cool ambient air passing along the foot airflow AF1 may enter the driver 10 through either of the foot inlet openings 200a, 200b from the second (left) lateral side 10d, and the heated air may exit the driver 10 through any of the foot outlet openings 204a, 204b, 204c as ejected along directions extending toward any or all of the working end 10a, the first (right) lateral side 10c, and the distal end 10b.

The motor impeller 90 generates (e.g., drives) motor airflow AF2 (e.g., suction airflow) from the motor inlet opening(s) 208 to the motor outlet opening(s) 212. The motor airflow AF2 may pass along and/or through the motor 62. Heat from the motor 62 may be transferred via convection from the motor 62 to the motor airflow AF2 and through the motor outlet opening(s) 212 to the surroundings of the driver 10. Relatively cool ambient air passing along the motor airflow AF2 may enter the driver 10 through either of the motor inlet openings 208a, 208b from the first (right) lateral side 10c and/or the working end 10a, and exit the driver 10 through any of the motor outlet openings 212a, 212b, 212c as ejected along directions extending toward any or all of the working end 10a, the first (right) lateral side 10c, and the distal end 10b.

While within the driver 10, the air passing along the foot airflow AF1 and the motor airflow AF2 are isolated from one another by the end wall 82b. Heat from the FETs 106c is isolated from heat generated by the motor 62 by the end wall 82b. After exiting the driver 10, heated air from both the foot airflow AF1 and the motor airflow AF2 may mix in the surroundings of the driver 10. I n other embodiments, another wall within the housing may isolate the foot airflow AF1 from the motor airflow AF2.

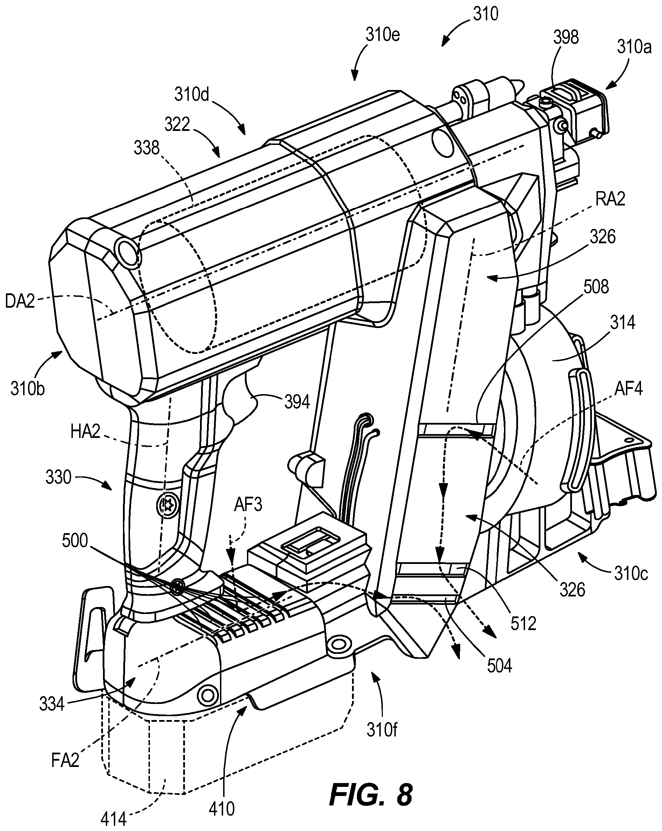

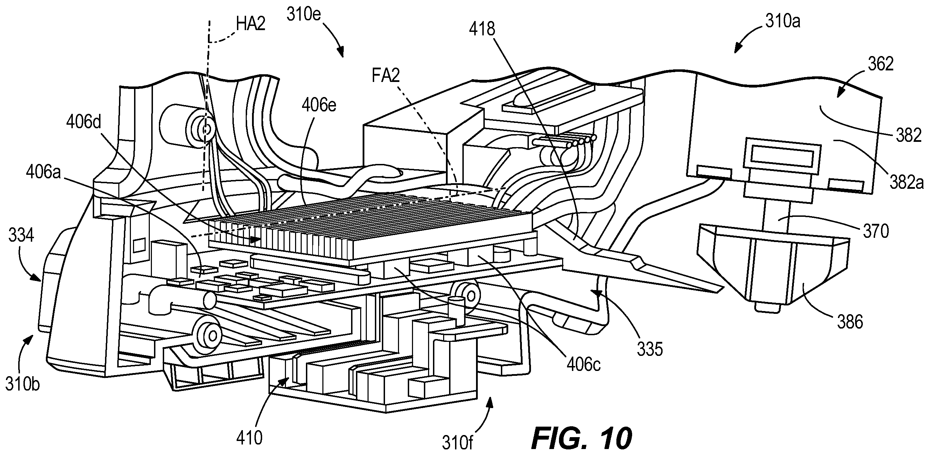

FIGS. 8-10 illustrate a gas spring-powered fastener driver (e.g., driver) 310 in accordance with another embodiment of the invention. The driver is generally similar to the driver 10 described above with reference to FIGS. 1-7, with like components between the driver 10 and the driver 310 being shown with like reference numerals plus 300 and with axes labels including the numeral '2'. For example, the driver 310 has a working end 310a, opposite distal end 310b, first and second lateral sides 310c, 310d, and first and second vertical sides 310e, 310f, is operable to drive fasteners from a magazine 314, and includes a receptacle 410 configured to receive a battery pack 414. The driver 310 further includes a PCBA 406 generally similar to the PCBA 106 with like components between the PCBA 106 and the PCBA 406 being shown with like reference numerals plus 300. Differences between the drivers 10, 310 are described below.

The driver 310 includes a foot impeller 386 and a motor impeller 390 each coupled to a rotor shaft 370 of a motor 362. The foot impeller 386 and motor impeller 390 are simultaneously driven upon activation of the motor 362. The foot impeller 386 generates (e.g., drives) foot airflow AF3 (e.g., suction airflow) from the foot inlet openings 500 (i.e., printed circuit board inlet openings) to the foot outlet opening 504 (i.e., printed circuit board outlet opening).

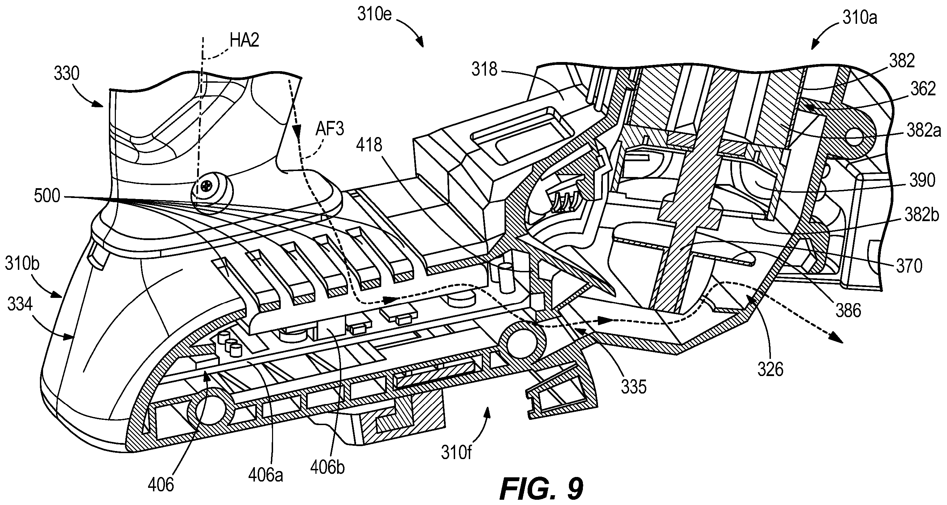

As illustrated in FIGS. 8 and 9, a housing 318 of the driver 310 includes a plurality of foot inlet openings 500 each positioned on a first vertical side 310e of a foot housing portion 334. In other words, the foot inlet openings 500 may be positioned on an inboard vertical side that faces the piston cylinder 338. The illustrated embodiment includes six foot inlet openings 500 dimensioned as separated slits. In other embodiments, more or fewer foot inlet openings 500 may be present. As illustrated in FIG. 8, the housing 318 includes a single foot outlet opening 504. The foot outlet opening 504 faces the first (right) lateral side 310c. Other embodiments may include more or fewer foot outlet openings 504, which may direct airflow exiting the driver 10 in any desired direction. The foot inlet openings 500 and the foot outlet opening 504 are through holes through the sidewalls of the foot housing portion 334 that permit fluid communication between the interior of the foot housing portion 334 and the surroundings (e.g., ambient air) of the driver 310. In some embodiments, one or more baffles (e.g., like the baffles 216) may be positioned within or adjacent to the openings 500, 504, to further direct airflow as it enters the driver 10.

As illustrated in FIG. 8, the housing 318 includes a single motor inlet opening 508 positioned on the motor housing portion 326 adjacent the working end 310a. Other embodiments may include two or more motor inlet openings 508 positioned adjacent any side of the driver 310 or may reposition the motor inlet opening 508 to a side other than adjacent the working end 310a. The housing 18 further includes a motor outlet opening 512 that faces the first (right) lateral side 310c. Other embodiments may include more motor outlet openings 512, which may direct airflow exiting the driver 310 in any desired direction, or may relocate the motor outlet opening 512 to direct airflow exiting the driver 310 in any desired direction. Each of the openings 508, 512 are through holes through the sidewalls of the motor housing portion 326 that permit fluid communication between the interior of the motor housing portion 326 and the surroundings (e.g., ambient air) of the driver 310. In some embodiments, baffles (e.g., like the baffles 216) may be positioned within or adjacent to the openings 508, 512 to further direct motor airflow AF4 as it exists the driver 10.

The PCBA 406 may include a heat sink 406d with heat sink fins 406e oriented along a fin axis FA2 that extends generally parallel to a drive axis DA2 from the distal end 310b toward the working end 310a. Other orientations of the fins 106e and the fin axis FA1 are possible. With this geometry and orientation, the foot airflow AF3 may pass along a high amount of surface area provided by the heat sink fins 406e, thus providing convective heat transfer capacity. The housing 318 may further include an interior baffle 418. The interior baffle 418 may provide support for the PCBA 406. The interior baffle 418 may also direct the foot airflow AF3 in a downward direction from the first vertical side 310e toward the second vertical side 310f as the foot airflow AF3 advances from the distal end 310b toward the working end 310a. The motor housing portion 326 may be laterally aligned with the drive axis DA2.

Operation of the driver 310 mimics the driver 10. As described above with regard to the driver 10, heat from the PCBA 406 may be transferred via convection by the foot airflow AF3, and through the foot outlet opening 504 to the surroundings of the driver 310. The motor impeller 390 generates (e.g., drives) motor airflow AF4 (e.g., suction airflow) from the motor inlet opening 508 to the motor outlet opening 512. As described above with regard to the driver 10, heat from the motor 362 may be transferred via convection by the motor airflow AF4, and through the motor outlet opening 512 to the surroundings of the driver 310. Substantively, the shape, directions, and quantity of inlets and outlets differs between both pairs of the foot airflow AF1 and the foot airflow AF3, and the motor airflow AF3 and the motor airflow AF4. The driver 310 generally provides differing flow path options in comparison to the driver 10.

Various features of the invention are set forth in the following claims.

## Claims

1. A power tool comprising:
a housing including a motor housing portion and a battery receptacle portion separate from the motor housing portion;
a motor coupled to and configured to drive a working element and at least one impeller, the motor positioned at least partially within the motor housing portion, the battery receptacle portion including a receptacle configured to receive a battery pack to provide electrical current to the motor; and
a printed circuit board including a heat-generating electrical component, the printed circuit board positioned within the battery receptacle portion;
wherein the at least one impeller is configured to generate airflow in a first airflow path within the motor housing portion and airflow in a second airflow path within the battery receptacle portion, the first airflow path and second airflow path being separate from one another.

2. The power tool of claim 1, further comprising a wall that physically separates an interior of the motor housing portion from an interior of the battery receptacle portion.

3. The power tool of claim 2, further comprising a motor casing within the motor housing portion, the motor casing surrounding at least a portion of the motor, the motor casing defining the wall.

4. The power tool of any one of claims 1 to 3, wherein the heat-generating electrical component is configured to control operation of the motor.

5. The power tool of any one of claims 1 to 4, further comprising a heat sink in thermal communication with the heat-generating electrical component, wherein preferably heat from the heat-generating electrical component is transferred via conduction from the heat-generating electrical component to the heat sink, and the heat is transferred via convection from the heat sink to the second airflow path prior to exhaust from the housing to the surroundings of the housing.

6. The power tool of any one of claims 1 to 5, wherein the first airflow path transfers heat generated by the motor from the motor housing portion to the surroundings of the housing and wherein the second airflow path transfers heat generated by the heat-generating electrical component from the battery receptacle portion to the surroundings of the housing.

7. A power tool, in particular the power tool of any one of the preceding claims, comprising:
a housing including a motor housing portion and a battery receptacle portion;
a motor coupled to and configured to drive a working element and at least one impeller, the motor positioned at least partially within the motor housing portion, the battery receptacle portion including a receptacle configured to receive a battery pack to provide electrical current to the motor;
a printed circuit board including a heat-generating electrical component, the printed circuit board positioned within the battery receptacle portion; and
a wall within the housing, the wall separating the motor housing portion and the battery receptacle portion;
wherein the at least one impeller is configured to generate airflow in a first airflow path within the motor housing portion and in a second airflow path within the battery receptacle portion, the first airflow path and second airflow path being separated from one another by the wall.

8. The power tool of any one of claims 1 to 7, further comprising a heat sink in thermal communication with the heat-generating electrical component.

9. The power tool of any one of claims 1 to 8, wherein the heat-generating electrical component is configured to control operation of the motor.

10. A powered fastener driver comprising:
a housing including a motor housing portion and a battery receptacle portion;
a wall within the housing and separating the motor housing portion and the battery receptacle portion;
a cylinder disposed within the housing;
a piston positioned and movable within the cylinder along a drive axis between a working end and a distal end opposite the working end;
a driver blade attached to and movable with the piston;
a motor to drive movement of the piston, the motor positioned within the motor housing portion, the motor including a rotor shaft, the battery receptacle portion including a receptacle configured to receive a battery pack to provide electrical current to the motor;
a printed circuit board including a heat-generating electrical component, the printed circuit board positioned in the battery receptacle portion;
a first impeller coupled to the rotor shaft within the motor housing portion, the first impeller configured to generate airflow in a first airflow path within the motor housing portion; and
a second impeller coupled to the rotor shaft within the battery receptacle portion, the second impeller configured to generate airflow in a second airflow path within the battery receptacle portion.

11. The power tool of any one of claims 1 to 9 or the powered fastener driver of claim 10, wherein the motor housing portion includes a motor inlet opening and a motor outlet opening, the first airflow path passing through the motor inlet opening and the motor outlet opening.

12. The power tool of any one of claims 1 to 9 or the powered fastener driver of either of claims 10 or 11, wherein:
the housing further includes a cylinder housing portion at least partially enclosing the cylinder and a handle portion connecting the cylinder housing portion and the battery receptacle portion,
a reference plane bisects the housing into a first side and a second side, the reference plane passing through the handle portion and intersecting the drive axis,
the motor housing portion includes a left lateral side on the first side of the housing, a right lateral side on the second side of the housing, a forward longitudinal side facing the working end of the drive axis, and rearward longitudinal side facing the distal end of the drive axis,
the motor inlet opening positioned on at least one of the right lateral side, the forward longitudinal side, and the rearward longitudinal side of the motor housing portion, and
the motor outlet opening is positioned on at least one of the right lateral side, and the forward longitudinal side, and the rearward longitudinal side of the motor housing portion.

13. The power tool of any one of claims 1 to 9 or the powered fastener driver of any one of claims 10 to 12, wherein the battery receptacle portion includes a printed circuit board inlet opening through which the second airflow path flows, further preferably comprising a passageway between the motor housing portion and the battery receptacle portion and a printed circuit board outlet opening, wherein:
the housing further includes a cylinder housing portion at least partially enclosing the cylinder and a handle portion connecting the cylinder housing portion and the battery receptacle portion,
a reference plane bisects the housing into a first side and a second side, the reference plane passing through the handle portion and intersecting the drive axis,
the battery receptacle portion includes a left lateral side on the first side of the housing, a right lateral side on the second side of the housing, a forward longitudinal side facing the working end of the drive axis, and a rearward longitudinal side facing the distal end of the drive axis,
the motor housing portion includes a left lateral side closest to the first side of the housing, a right lateral side on the second side of the housing, a forward longitudinal side facing the working end of the drive axis, and a rearward longitudinal side facing the distal end of the drive axis,
the printed circuit board inlet opening is positioned on the left lateral side of the battery receptacle portion, and
the printed circuit board outlet opening is positioned on at least one of the right lateral side of the motor housing portion, the forward longitudinal side of the motor housing portion, and the rearward longitudinal side of the motor housing portion, wherein further preferably the second airflow path flows from the printed circuit board inlet opening on the left lateral side of the battery receptacle portion, through the passageway, and through the printed circuit board outlet opening.

14. The power tool of any one of claims 1 to 9 or the powered fastener driver of any one of claims 10 to 13, further comprising a heat sink in thermal communication with the heat-generating electrical component,
wherein the heat sink is in thermal communication with the heat-generating electrical component, the heat sink including a plurality of heat sink fins which define channels between adjacent heat sink fins,
wherein preferably at least one of the channels traverses the reference plane, and
wherein further preferably the channels are oriented in a direction extending laterally and forwardly from the printed circuit board inlet opening and toward the printed circuit board outlet opening.

15. The power tool of any one of claims 1 to 9 or the powered fastener driver of any one of claims 10 to 14, wherein the battery receptacle portion includes a side facing the cylinder housing portion, and the printed circuit board inlet opening is positioned on the side.
